# EUROPEAN PATENT SPECIFICATION

(11) **EP 4 113 601 B1**
(45) Date of publication and mention of the grant of the patent: **27.03.2024**
(21) Application number: 22181350.4
(22) Date of filing: 27.06.2022
(51) Int. Cl.: H01L 23/498, H01L 23/495

(54) **METHOD OF MANUFACTURING SUBSTRATES FOR SEMICONDUCTOR DEVICES, CORRESPONDING SUBSTRATE AND SEMICONDUCTOR DEVICE**
VERFAHREN ZUR HERSTELLUNG VON SUBSTRATEN FÜR HALBLEITERBAUELEMENTE, ENTSPRECHENDES SUBSTRAT UND HALBLEITERBAUELEMENT
PROCÉDÉ DE FABRICATION DE SUBSTRATS POUR DISPOSITIFS À SEMICONDUCTEUR, SUBSTRAT CORRESPONDANT ET DISPOSITIF À SEMICONDUCTEUR

(30) Priority: 30.06.2021 IT 202100017231
(43) Date of publication of application: 04.01.2023
(73) Proprietor: STMicroelectronics S.r.l., 20864 Agrate Brianza (MB) (IT)
(72) Inventor: MAZZOLA, Mauro, 24040 Calvenzano (Bergamo) (IT)
(74) Representative: Bosotti, Luciano

(56) References cited:
- DE-A1-102016 106 311
- US-A1- 2018 096 861

## Description

### Technical field

The description relates to manufacturing semiconductor devices.

One or more embodiments may apply to manufacturing pre-molded leadframes for semiconductor devices.

### Background

Semiconductor devices may comprise one or more semiconductor chips or dice arranged (attached) on a substrate such as a leadframe.

Plastic packages are commonly used for semiconductor devices. Such packages may include a leadframe providing a base substrate comprising electrically conductive material such as copper, sized and shaped to accommodate semiconductor chips or dice and providing pad connections (leads) for these chips or dice.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Leadframes are conventionally created using technologies such as a photo-etching technology. With this technology, metal (e.g., copper) material in the form of a foil or tape is etched on the top and bottom sides to create various pads and leads.

So-called "pre-molded" leadframes include electrically insulating resin such as epoxy resin, for instance, molded onto a sculptured (e.g., photo-etched) metal leadframe structure using a flat molding tool, for instance. US2018096861 discloses a pre-molded leadframe, wherein adjacent die pads are connected by stabilizing elements.

Spaces left in the etched metal material are filled by pre-mold resin and the resulting leadframe has a total thickness which is the same thickness of the original etched leadframe.

After pre-molding (with the molded resin solidified, via heat or UV curing, for instance), deflashing and smearing processes can be applied to provide clean top/bottom metal surfaces of the leadframe.

Such pre-molded leadframes are used in a wide variety of semiconductor devices.

Certain pre-molded leadframes (for instance, for use in power semiconductor devices packaged in Quad-Flat No-leads or QFN packages) may include plural die pads for arranging semiconductor chips or dies and associated components.

These die pads are intended to be finally isolated from one another. However, connecting bars are useful in mechanically coupling these pads either to a metal (e.g., copper) frame in the leadframe and/or to other die pads in the leadframe while the pre-mold resin is molded onto the sculptured metal structure of the leadframe.

These connecting bars are useful in avoiding negative phenomena such as undesired displacement of the die pads or "flashing" of the pre-mold resin over the metal surfaces of the leadframe.

The connecting bars are then removed, for instance during a subsequent (half) etching process applied to the pre-molded leadframe to form wettable flanks for soldering.

This processing may however leave certain defects that are difficult to control in production and may result in part rejection or quality issues at the customer board level.

### Object and summary

An object of one or more embodiments is to contribute in avoiding the drawbacks outlined in the foregoing.

According to one or more embodiments, that object can be achieved by means of a method having the features set forth in the claims that follow.

One of more embodiments relate to a corresponding (pre-molded) leadframe.

One of more embodiments relate to a corresponding semiconductor device. A QFN power device may be exemplary of such a device.

The claims are an integral part of the technical teaching provided herein in respect of the embodiments.

One or more embodiments propose a design for the metal (e.g., copper) bottom and top sides of a leadframe which provides temporary (sacrificial) connection bars that can be removed without negatively affecting the die pad outline on the back or bottom side of the device package, for instance.

One or more embodiments do not involve additional process steps over conventional pre-molded leadframe manufacturing.

One or more embodiments may provide a multi-die pad pre-molded leadframe including die pad connection bars with a bridge-like portion at the back (or bottom) side of the leadframe. Such a bridge-like portion is arranged remote from the die pads connected thereby and can be removed during subsequent processing (such as a second half-etching step after molding) without adverse effects on the outline of the die pads.

One or more embodiments effectively reduce part rejection due to die pad defects. Visual inspection of a semiconductor device (a power QFN package, for instance) comprising a pre-molded leadframe according to embodiments will thus identify die pads (of the low-voltage die, for instance) with a regular (virtually perfect) rectangular outline with a recessed portion (cavity) in the molding exposing two sides of the bridge "opened" as a result of a connecting bar being removed.

### Brief description of the figures

One or more embodiments will now be described, by way of example only, with reference to the annexed figures, wherein:
Figures 1A and 1B are plan views of a pre-molded leadframe,
Figure 1C shows the views of Figures 1A and 1B mutually superposed,
Figure 2 is a view of the portion of Figure 1C indicated by arrow II reproduced on an enlarged scale,
Figure 3 is a cross-sectional view along line III-III of Figure 2,
Figure 4 is a view of a pre-molded leadframe substantially corresponding to Figure 1C, after removal of a connection element as discussed herein,
Figure 5 is a view of the portion of Figure 4 indicated by arrow V reproduced on an enlarged scale, and
Figure 6 is a cross-sectional view along line VI-VI in Figure 5.

Corresponding numerals and symbols in the different figures generally refer to corresponding parts unless otherwise indicated. The figures are drawn to clearly illustrate the relevant aspects of the embodiments and are not necessarily drawn to scale. The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the structure of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments

Semiconductor devices such as, for instance, power devices, comprise a substrate (leadframe) onto which semiconductor chips or dice and other electrical components are mounted with solder glue or other processes, with wires and/or "ribbons" providing electrical connection to the semiconductor chips.

An encapsulation of molding resin (an epoxy resin, for instance) incorporates these elements in a (plastic) main body of the semiconductor device.

A substrate or leadframe 12 is produced starting from a foil or strip of metal material (copper) for instance, onto which a "sculptured" conformation is bestowed by photoetching technology, for instance.

In pre-molded leadframes a pre-mold resin is molded onto the sculptured metal structure of the leadframe to fill the spaces left free therein. The resulting "pre-molded" leadframe has the same thickness of the original metal material sheet or foil.

Further processing (for instance a second etching step) can be applied to the pre-mold leadframe to remove additional copper for various reasons, to provide wettable flanks for soldering or connecting bars, for instance.

Pre-molded leadframes may include two or more die pads (that is areas onto which semiconductor chips and/or other components are intended to be attached) and may exhibit a complex design.

This makes connection to outer bars in the leadframe difficult, especially if pad number maximisation is pursued.

Stability, that is, avoiding undesired deformation/displacement during pre-molding and saving space for additional pads are factors suggesting that temporary (sacrificial) connection bars are formed between adjacent die pads at the bottom or back side of the sculptured metal structure of the leadframe.

These bars are finally removed, e.g., via a chemical reaction during a second etching step, so that the die pads are finally isolated (mechanically and electrically) from one another.

This processing can be detected by visual inspection of the back or bottom side of the pre-molded leadframe, with void spaces (cavities) visible where metal (copper, for instance) was removed thus exposing the pre-mold resin.

Unless otherwise indicated, leadframe processing as discussed in the foregoing is conventional in the art, which makes it unnecessary to provide a more detailed description herein.

A problem encountered in performing operations as discussed in the foregoing is related to tolerances inherent in processes such as etching, which ultimately have an impact on the final shape (outline) of the die pads.

For instance, undesirably poor etching may result in metal material remaining that exceeds (that is, undesirably protrudes) from the desired rectangular shape of a die pad.

Alternatively, in the case of over-etching, metal material can be undesirably removed from the periphery of the die pad again resulting in an undesirably irregular rectangular die pad shape.

That is:
in the case of poor etching, undesired metal material may remain attached, and
in the case of over-etching, more material than desired may be removed.

In both cases, the shape of die pad will exhibit undesired uncontrolled protrusions or notches that are regarded as defects of the pre-molded leadframe.

These defects are visible at the die pad surfaces and deviations from a desired (e.g., substantially rectangular) shape may negatively affect package resistance and/or solder joint reliability.

Such drawbacks may be attempted to be palliated by controlling more accurately the parameters of the second etching process, for instance, and/or modifying the solder etching mask at the substrate (a printed circuit board or PCB, for instance) onto which the semiconductor product is mounted.

These solutions may undesirably add to the cost of manufacturing the leadframe and the corresponding semiconductor device without completely overcoming the drawbacks discussed in the foregoing.

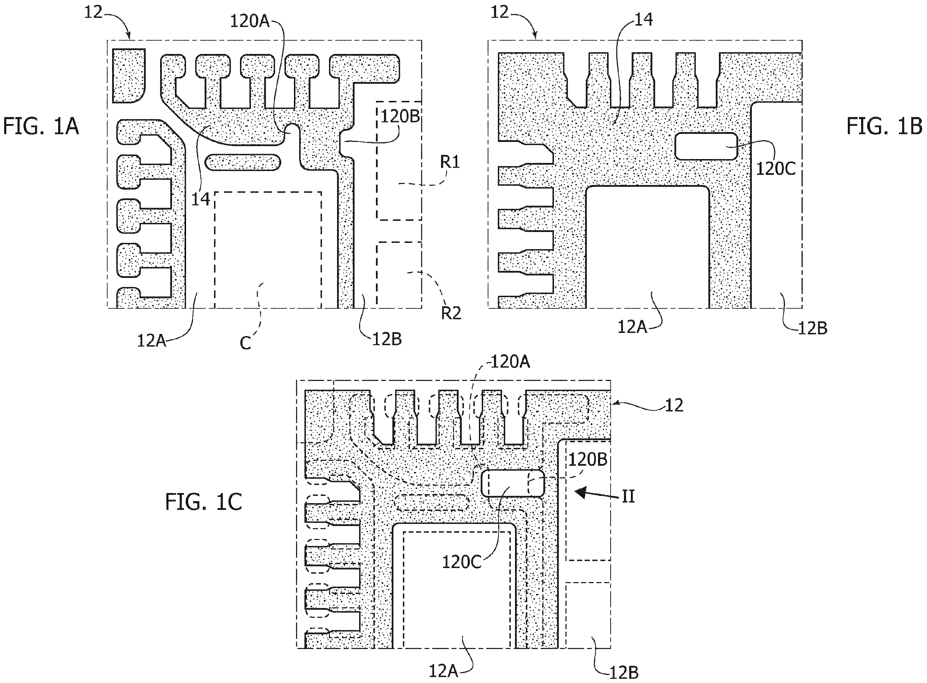

Figures 1A and 1B are plan views (at the level of the top or front side and at the level of the bottom or back side, respectively) of a portion of pre-molded leadframe 12.

As discussed previously (and as otherwise conventional in the art), the leadframe 12 comprises a sculptured metal (e.g., copper) structure - formed by etching a metal foil or strip - including a plurality of die pads onto which one or more semiconductor chips and associated components are intended to be mounted, via a die-attach material, for instance.

For the sake of simplicity and ease of explanation, the description and the figures refer to the presence of (only) two die pads, indicated 12A and 12B, respectively. As noted, one or more embodiments can be advantageously applied to leadframes comprising a higher number (three or more) of die pads.

As illustrated only in Figure 1A, the die pads 12A and 12B are intended to host attached thereon semiconductor chips or dice or, possibly, components such as "ribbons" this being particularly the case of a power device.

Those of skill in art will otherwise appreciate that embodiments are discussed herein are largely "transparent" to the nature and configuration of the components such as C, R1, R2 intended to be mounted onto the die pads such as 12A, 12B.

In the examples described herein, the two die pads 12A and 12B are assumed to be (temporarily) connected via one (or, advantageously, plural) sacrificial connection bars while pre-mold resin 14 is molded onto the metal structure of the leadframe 12 to provide a pre-molded leadframe as otherwise conventional in the art.

The sacrificial connection bars are then at least partially removed so that the two die pads 12A and 12B are finally isolated.

The examples illustrated refer for simplicity and ease of explanation to one such connecting bar comprising:
respective extensions 120A, 120B of the (electrically conductive) die pads 12A, 12B, at one of the surfaces (the front or top surface, for instance) of the leadframe 12, and
an (electrically conductive) bridge element 120C coupling the extensions 120A, 120B, the bridge element 120C being provided on the opposed surface (here the back or bottom surface, for instance) of the leadframe 12.

The element 120C extends bridge-like between the extensions 120A, 120B being de facto one-piece therewith thus providing (temporary) mechanical and electrical connection between the die pads 12A, 12B.

Again, while a single set of two extensions 120A, 120B from the die pads 13A, 12B and a connecting element 120C extending bridge-like therebetween is illustrated here for simplicity, a plurality of such sets can be provided in the leadframe 12 at locations where plural die pads such as 12A, 12B are desired to be (temporarily) connected during pre-molding.

The spatial relationship between the extensions 120A, 120B (on one side of the leadframe) and the bridge element 120C (on the other side of the leadframe) is further exemplified in Figure 1C.

Figure 1C essentially reproduces the plan view of the leadframe 12 at the level of the back or bottom surface as illustrated in Figure 1B with the layout of the metal parts of the leadframe 12 at the front or top surface of the leadframe 12 reproduced in dashed lines.

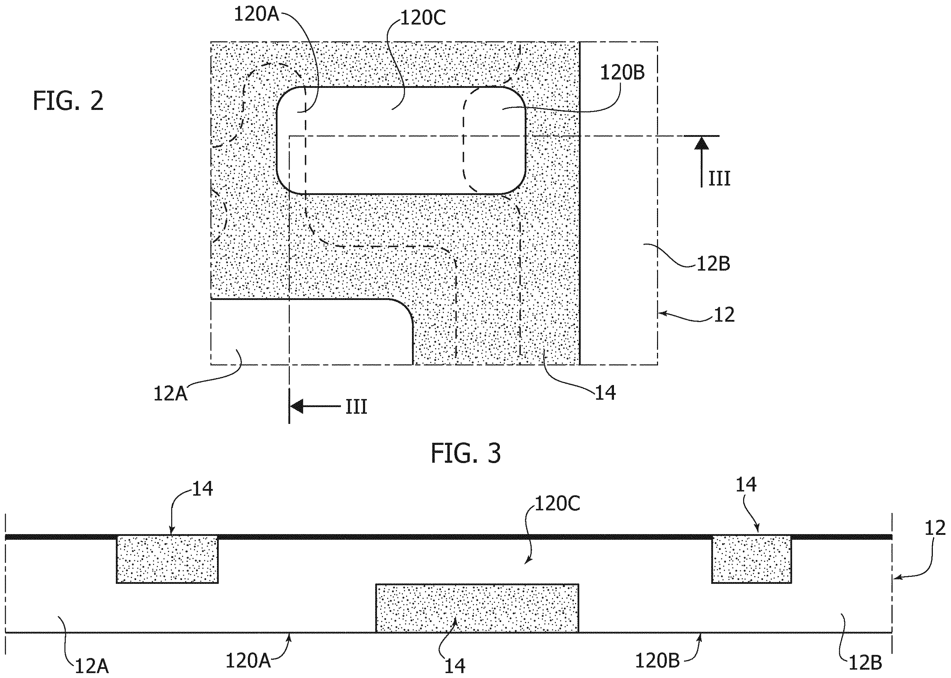

This spatial relationship is further exemplified in the enlarged view of Figure 2 with the cross-sectional view of Figure 3 further detailing the relative positions of extensions 120A, 120B and the bridge 120C therebetween.

It will be appreciated that:
the cross-sectional view of Figure 3 is taken along line III-III Figure 2, such a line having a 90° bend at the extension 120A (with an end portion of the bridge element 120C located in a corresponding position on the opposite side of the leadframe 12); and
in the cross-sectional view of Figure 3 the bottom or back surface of the leadframe 12 faces upwards while the top or front surface faces downwards.

Also, while preserving the connection therebetween, both extensions 120A and 120B, as well as the bridge-like element 120C can be shaped and sized with a certain degree of freedom.

Advantageously, the extensions 120A, 120B are formed at neighbouring locations so that the distal ends of these extensions are located at a short distance therebetween.

A rectilinear or substantially rectilinear (quadrangular) shape was found to be advantageous for the extensions 120A, 120B.

Similarly, a linear (e.g., rectangular) shape with rounded edges was found to be advantageous for the bridge- like connecting element 120C.

The cross-sectional view of Figure 3 illustrates the possibility for the pre-molding encapsulation material to penetrate into the sculptured metal (e.g., copper) structure of the leadframe 12 filling the empty spaces therein.

Figures 1A to 1C, 2, and 3 are thus exemplary of molding electrically insulating material such as 14 onto a laminar sculptured structure of electrically conductive material to produce a leadframe 12 comprising a plurality of die pads 12A, 12B configured to have semiconductor device components C, R1, R2 mounted thereon.

The leadframe 12 has opposed first and second surfaces and one (or more) pairs of die pads 12A, 12B. As illustrated these die pads 12A, 12B are coupled via (at least one) sacrificial coupling formation intended to be at least partly removed; this is after this or these sacrificial coupling formations have assisted in countering undesired displacement of the die pads while electrically insulating material (that is, the pre-mold resin 14) is molded onto the laminar sculptured structure of electrically conductive material of the leadframe 12.

In that way, the die pads 12A, 12B can be finally decoupled as desired.

As illustrated, a first extension 120A of the first die pad 12A and a second extension 120B of the second die pad 12B are provided at a first surface (e.g the front or top surface) of the laminar sculptured structure of electrically conductive material, for instance during manufacturing that metal (e.g., copper) structure as otherwise convetional in the art (e.g., via photo-etching) .

As illustrated, the extensions 120A and 120B are provided (formed) at neighboring locations of the first surface of the leadframe 12.

As illustrated, an (electrically conductive) formation 120C is provided at the second surface (e.g., the back or bottom surface) of the laminar sculptured structure of the leadframe 12. Again, this may occur during manufacturing that metal (e.g., copper) structure as otherwise conventional in the art.

As visible in Figure 3, for instance, the formation 120C extends bridge-like between the first extension 120A and the second extension 120B thus providing a sacrificial coupling formation (connecting bar) of the die pads 12A, 12B.

As illustrated, the first extension 120A and the second extension 120B are advantageously provided as finger-like extensions and/or advantageously have distal ends located at a distance from the die pads 12A, 12B with the element or formation 120C extending bridge-like between these distal ends.

As a result, the formation 120C ends up by being located at a distance from the die pads 12A, 12B.

Advantageously, the first extension 120A and the second extension 120B are provided as mutually converging extensions from the die pads 12A, 12B.

As discussed, the sacrificial coupling formation(s) such as 120A, 120B, 120C are at least partly removed to isolate the die pads 12A, 12B after molding (and solidifying, via heat or UV curing for instance) the insulating pre-mold material 14 which penetrates (see Figure 3, for instance) into the empty spaces in the laminar sculptured metal structure of the leadframe 12.

Such an at least partial removal may involve at least partly removing (e.g., during a further etching step for forming solder wettable flanks, for instance) the formation 120C extending bridge-like between the first extension 120A and the second extension 120B.

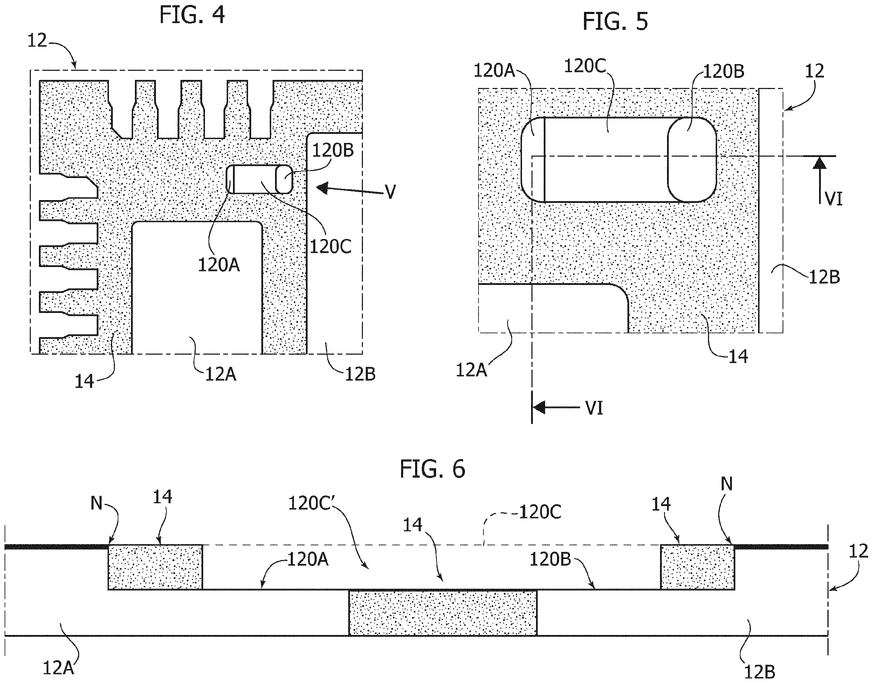

Skipping for simplicity to Figure 6, one may note that:
as a result of the bridge formation 120C (whose outline is shown in a dashed line) being removed, the die pads 12A, 12B still exhibit, at neighboring locations of the front or top surface of the leadframe (pointing downwards in Figure 6) a first extension 120A and a second extension 120B,
conversely, the back or bottom surface of the leadframe 12 has a recessed portion (cavity) 120C' extending bridge-like (at the back or bottom surface of the leadframe 12) between the first extension 120A and the second extension 120B (these latter being provided at the front or top surface of the lead frame).

As exemplified in the views of Figures 4 and 5, removing the bridge formation or element 120C (via "secondary" etching, for instance) leaves in the cavity 120C very "clean" surfaces N towards the surrounding metal parts.

The die pads 12A, 12B are thus separated without creating undesired defects (protrusions due to poor etching or notches due to over-etching, for instance) in their outline.

As exemplified in the views of Figures 4 and 5, the bridge-like element 120C is thus removed without adversely affecting the profile of the die pads 12A, 12B. That is, no defects are produced on the exposed surfaces of the die pads 12A, 12B, as a result of the connection bar represented by the bridge element 120C being removed.

It will be appreciated that the die pad extensions 120A, 120B provided on the opposed (here front or top) surface are in no way affected by the removal of the bridge-like element (connecting bar) 120C.

The extent of protection is determined by the annexed claims.

## Claims

1. A method, comprising:
molding electrically insulating material (14) onto a laminar sculptured structure of electrically conductive material to produce a leadframe (12) comprising a plurality of die pads (12A, 12B) configured to have semiconductor device components (C, R1, R2) mounted thereon, the leadframe (12) having opposed first and second surfaces,
**characterized by**
providing in at least one pair of die pads (12A, 12B) in the plurality of die pads a first extension (120A) and a second extension (120B) at neighboring locations of the first surface of the leadframe (12),
providing in the laminar sculptured structure of electrically conductive material, at the second surface of the leadframe, a bridge formation (120C) coupling said first extension (120A) and said second extension (120B), wherein the first extension (120A) and the second extension (120B) plus the bridge formation (120C) therebetween provide a coupling formation (120A, 120B, 120C) of said pair of die pads in the plurality of die pads (12A, 12B), and
subsequent to molding the electrically insulating material (14) onto the laminar sculptured structure of electrically conductive material, at least partly removing the bridge formation (120C) between the first extension (120A) and the second extension (120B) to decouple the die pads (12A, 12B) in said at least one pair of die pads.

2. The method of claim 1, wherein the plurality of die pads (12A, 12B) are configured to have semiconductor device components (C, R1, R2) mounted thereon at said first surface of the leadframe (12).

3. The method of claim 1 or claim 2, comprising:
providing the first extension (120A) and the second extension (120B) with distal ends located at a distance from the die pads (12A, 12B) in the at least one pair of die pads in the plurality of die pads (12A, 12B), and
providing the bridge formation (120C) between said distal ends of the first extension (120A) and the second extension (120B), wherein the bridge formation (120C) is located at a distance from the die pads (12A, 12B) in the at least one pair of die pads in the plurality of die pads (12A, 12B).

4. The method of any of claims 1 to 3, comprising providing the first extension (120A) and the second extension (120B) as finger-like extensions from the die pads (12A, 12B) in the at least one pair of die pads in the plurality of die pads (12A, 12B).

5. The method of any of the previous claims, comprising providing the first extension (120A) and the second extension (120B) as mutually converging extensions from the die pads (12A, 12B) in the at least one pair of die pads in the plurality of die pads (12A, 12B) .

6. A pre-molded leadframe (12) for semiconductor devices, comprising:
electrically insulating material (14) molded onto a laminar sculptured structure of electrically conductive material, the leadframe (12) comprising a plurality of die pads (12A, 12B) configured to have semiconductor device components (C, R1, R2) mounted thereon, the leadframe (12) having opposed first and second surfaces,
**characterized in that**
at least one pair of die pads in the plurality of die pads (12A, 12B) exhibit, at neighboring locations of the first surface of the leadframe (12), a first extension (120A) and a second extension (120B), and
the second surface of the leadframe (12) has a recessed portion (120C') extending bridge-like between said first extension (120A) and said second extension (120B).

7. The pre-molded leadframe (12) of claim 6, wherein the plurality of die pads (12A, 12B) are configured to have semiconductor device components (C, R1, R2) mounted thereon at the first surface of the leadframe (12).

8. The pre-molded leadframe (12) of claim 6 or claim 7, wherein:
the first extension (120A) and the second extension (120B) have distal ends located at a distance from the die pads (12A, 12B) in the at least one pair of die pads in the plurality of die pads (12A, 12B), and
said recessed portion (120C') is located at a distance from the die pads (12A, 12B) in the at least one pair of die pads in the plurality of die pads (12A, 12B) .

9. The pre-molded leadframe (12) of any of claims 6 to 8, wherein the first extension (120A) and the second extension (120B) comprise finger-like extensions from the die pads (12A, 12B) in the at least one pair of die pads in the plurality of die pads (12A, 12B).

10. The pre-molded leadframe (12) of any of claims 6 to 9, wherein the first extension (120A) and the second extension (120B) comprise mutually converging extensions from the die pads (12A, 12B) in the at least one pair of die pads in the plurality of die pads (12A, 12B).

11. A semiconductor device, comprising:
a pre-molded leadframe (12) according to any of claims 6 to 10, and
semiconductor device components (C, R1, R2) arranged onto the die pads (12A, 12B) in the at least one pair of die pads in the plurality of die pads (12A, 12B) .

## Patentansprüche

1. Verfahren, umfassend:
Anformen von elektrisch isolierendem Material (14) an eine modellierte Laminarstruktur aus elektrisch leitfähigem Material, um einen Leiterrahmen (12) herzustellen, der eine Vielzahl von Chipunterbauten (12A, 12B) umfasst, die konfiguriert sind, um darauf angebrachte Halbleitervorrichtungskomponenten (C, R1, R2) aufzuweisen, wobei der Leiterrahmen (12) gegenüberliegende erste und zweite Oberflächen aufweist,
**gekennzeichnet durch**
Bereitstellen in mindestens einem Paar von Chipunterbauten (12A, 12B) der Vielzahl von Chipunterbauten eines ersten Fortsatzes (120A) und eines zweiten Fortsatzes (120B) an benachbarten Stellen der ersten Oberfläche des Leiterrahmens (12),
Bereitstellen in der modellierten Laminarstruktur aus elektrisch leitfähigem Material, an der zweiten Oberfläche des Leiterrahmens, einer Brückenformation (120C), welche den ersten Fortsatz (120A) und den zweiten Fortsatz (120B) koppelt, wobei der erste Fortsatz (120A) und der zweite Fortsatz (120B) plus die Brückenformation (120C) dazwischen eine Kopplungsformation (120A, 120B, 120C) des Paares von Chipunterbauten (12A, 12B) bereitstellen, und
anschließend an das Anformen des elektrisch isolierenden Materials (14) an die modellierte Laminarstruktur aus elektrisch leitfähigem Material mindestens teilweise Entfernen der Brückenformation (120C) zwischen dem ersten Fortsatz (120A) und dem zweiten Fortsatz (120B), um die Chipunterbauten (12A, 12B) in dem mindestens einen Paar von Chipunterbauten zu entkoppeln.

2. Verfahren nach Anspruch 1, wobei die Vielzahl von Chipunterbauten (12A, 12B) konfiguriert sind, um darauf angebrachte Halbleitervorrichtungskomponenten (C, R1, R2) auf der ersten Oberfläche des Leiterrahmens (12) aufzuweisen.

3. Verfahren nach Anspruch 1 oder Anspruch 2, umfassend:
Bereitstellen des ersten Fortsatzes (120A) und des zweiten Fortsatzes (120B) mit distalen Enden, die sich in einem Abstand von den Chipunterbauten (12A, 12B) in dem mindestens einen Paar von Chipunterbauten in der Vielzahl von Chipunterbauten (12A, 12B) befinden, und
Bereitstellen der Brückenformation (120C) zwischen den distalen Enden des ersten Fortsatzes (120A) und des zweiten Fortsatzes (120B), wobei sich die Brückenformation (120C) in einem Abstand von den Chipunterbauten (12A, 12B) in dem mindestens einen Paar von Chipunterbauten in der Vielzahl von Chipunterbauten (12A, 12B) befindet.

4. Verfahren nach einem der Ansprüche 1 bis 3, umfassend das Bereitstellen des ersten Fortsatzes (120A) und des zweiten Fortsatzes (120B) als fingerähnliche Fortsätze aus den Chipunterbauten (12A, 12B) in dem mindestens einen Paar von Chipunterbauten in der Vielzahl von Chipunterbauten (12A, 12B).

5. Verfahren nach einem der vorstehenden Ansprüche, umfassend das Bereitstellen des ersten Fortsatzes (120A) und des zweiten Fortsatzes (120B) als zueinander zusammenlaufende Fortsätze aus den Chipunterbauten (12A, 12B) in dem mindestens einen Paar von Chipunterbauten in der Vielzahl von Chipunterbauten (12A, 12B).

6. Vorgeformter Leiterrahmen (12) für Halbleitervorrichtungen, umfassend:
elektrisch isolierendes Material (14), das an eine modellierte Laminarstruktur aus elektrisch leitfähigem Material angeformt ist, wobei der Leiterrahmen (12) eine Vielzahl von Chipunterbauten (12A, 12B) umfasst, die konfiguriert sind, um darauf angebrachte Halbleitervorrichtungskomponenten (C, R1, R2) aufzuweisen, wobei der Leiterrahmen (12) gegenüberliegende erste und zweite Oberflächen aufweist,
**dadurch gekennzeichnet, dass**
mindestens ein Paar von Chipunterbauten in der Vielzahl von Chipunterbauten (12A, 12B) an benachbarten Stellen der ersten Oberfläche des Leiterrahmens (12) einen ersten Fortsatz (120A) und einen zweiten Fortsatz (120B) besitzt, und
die zweite Oberfläche des Leiterrahmens (12) einen ausgesparten Abschnitt (120C') aufweist, der sich brückenähnlich zwischen dem ersten Fortsatz (120A) und dem zweiten Fortsatz (120B) erstreckt.

7. Vorgeformter Leiterrahmen (12) nach Anspruch 6, wobei die Vielzahl von Chipunterbauten (12A, 12B) konfiguriert sind, um darauf angebrachte Halbleitervorrichtungskomponenten (C, R1, R2) auf der ersten Oberfläche des Leiterrahmens (12) aufzuweisen.

8. Vorgeformter Leiterrahmen (12) nach Anspruch 6 oder Anspruch 7, wobei:
der erste Fortsatz (120A) und der zweite Fortsatz (120B) distale Enden aufweisen, die sich in einem Abstand von den Chipunterbauten (12A, 12B) in dem mindestens einen Paar von Chipunterbauten in der Vielzahl von Chipunterbauten (12A, 12B) befinden, und
der ausgesparte Abschnitt (120C') sich in einem Abstand von den Chipunterbauten (12A, 12B) in dem mindestens einen Paar von Chipunterbauten in der Vielzahl von Chipunterbauten (12A, 12B) befindet.

9. Vorgeformter Leiterrahmen (12) nach einem der Ansprüche 6 bis 8, wobei der erste Fortsatz (120A) und der zweite Fortsatz (120B) fingerähnliche Fortsätze aus den Chipunterbauten (12A, 12B) in dem mindestens einen Paar von Chipunterbauten in der Vielzahl von Chipunterbauten (12A, 12B) umfassen.

10. Vorgeformter Leiterrahmen (12) nach einem der Ansprüche 6 bis 9, wobei der erste Fortsatz (120A) und der zweite Fortsatz (120B) zueinander zusammenlaufende Fortsätze aus den Chipunterbauten (12A, 12B) in dem mindestens einen Paar von Chipunterbauten in der Vielzahl von Chipunterbauten (12A, 12B) umfassen.

11. Halbleitervorrichtung, umfassend:
einen vorgeformten Leiterrahmen (12) nach einem der Ansprüche 6 bis 10, und
Halbleitervorrichtungskomponenten (C, R1, R2), die an den Chipunterbauten (12A, 12B) in dem mindestens einen Paar von Chipunterbauten in der Vielzahl von Chipunterbauten (12A, 12B) angeordnet sind.

## Revendications

1. Procédé, comprenant :
le moulage d'un matériau électriquement isolant (14) sur une structure sculptée laminaire d'un matériau électroconducteur pour produire une grille de connexion (12) comprenant une pluralité de plages de connexion (12A, 12B) configurées de sorte que des composants de dispositif à semiconducteur (C, R1, R2) soient montés sur celles-ci, la grille de connexion (12) ayant une première et une deuxième surface opposées,
**caractérisé par**
la fourniture, dans au moins une paire de plages de connexion (12A, 12B) dans la pluralité de plages de connexion, d'une première extension (120A) et d'une deuxième extension (120B) à des emplacements voisins de la première surface de la grille de connexion (12),
la fourniture, dans la structure sculptée laminaire d'un matériau électroconducteur, au niveau de la deuxième surface de la grille de connexion, d'une formation de pont (120C) couplant ladite première extension (120A) et ladite deuxième extension (120B), dans lequel la première extension (120A) et la deuxième extension (120B) plus la formation de pont (120C) entre elles fournissent une formation de couplage (120A, 120B, 120C) de ladite paire de plages de connexion dans la pluralité de plages de connexion (12A, 12B), et
à la suite du moulage du matériau électriquement isolant (14) sur la structure sculptée laminaire d'un matériau électroconducteur, le retrait au moins partiel de la formation de pont (120C) entre la première extension (120A) et la deuxième extension (120B) pour découpler les plages de connexion (12A, 12B) dans ladite au moins une paire de plages de connexion.

2. Procédé selon la revendication 1, dans lequel la pluralité de plages de connexion (12A, 12B) sont configurées de sorte que des composants de dispositif à semiconducteur (C, R1, R2) soient montés sur celles-ci au niveau de ladite première surface de la grille de connexion (12).

3. Procédé selon la revendication 1 ou la revendication 2, comprenant :
la fourniture de la première extension (120A) et de la deuxième extension (120B) avec des extrémités distales situées à une certaine distance des plages de connexion (12A, 12B) dans l'au moins une paire de plages de connexion dans la pluralité de plages de connexion (12A, 12B), et
la fourniture de la formation de pont (120C) entre lesdites extrémités distales de la première extension (120A) et de la deuxième extension (120B), dans lequel la formation de pont (120C) est située à une certaine distance des plages de connexion (12A, 12B) dans l'au moins une paire de plages de connexion dans la pluralité de plages de connexion (12A, 12B).

4. Procédé selon l'une quelconque des revendications 1 à 3, comprenant la fourniture de la première extension (120A) et de la deuxième extension (120B) en tant qu'extensions en forme de doigt à partir des plages de connexion (12A, 12B) dans l'au moins une paire de plages de connexion dans la pluralité de plages de connexion (12A, 12B).

5. Procédé selon l'une quelconque des revendications précédentes, comprenant la fourniture de la première extension (120A) et de la deuxième extension (120B) en tant qu'extensions convergeant mutuellement à partir des plages de connexion (12A, 12B) dans l'au moins une paire de plages de connexion dans la pluralité de plages de connexion (12A, 12B).

6. Grille de connexion prémoulée (12) pour dispositifs à semiconducteur, comprenant :
un matériau électriquement isolant (14) moulé sur une structure sculptée laminaire d'un matériau électroconducteur, la grille de connexion (12) comprenant une pluralité de plages de connexion (12A, 12B) configurées de sorte que des composants de dispositif à semiconducteur (C, R1, R2) soient montés sur celles-ci, la grille de connexion (12) ayant une première et une deuxième surface opposées,
**caractérisée en ce que**
au moins une paire de plages de connexion dans la pluralité de plages de connexion (12A, 12B) présentent, à des emplacements voisins de la première surface de la grille de connexion (12), une première extension (120A) et une deuxième extension (120B) et
la deuxième surface de la grille de connexion (12) a une partie évidée (120C') s'étendant sous la forme d'un pont entre ladite première extension (120A) et ladite deuxième extension (120B).

7. Grille de connexion prémoulée (12) selon la revendication 6, dans laquelle la pluralité de plages de connexion (12A, 12B) sont configurées de sorte que des composants de dispositif à semiconducteur (C, R1, R2) soient montés sur celles-ci au niveau de la première surface de la grille de connexion (12).

8. Grille de connexion prémoulée (12) selon la revendication 6 ou la revendication 7, dans laquelle :
la première extension (120A) et la deuxième extension (120B) ont des extrémités distales situées à une certaine distance des plages de connexion (12A, 12B) dans l'au moins une paire de plages de connexion dans la pluralité de plages de connexion (12A, 12B), et
ladite partie évidée (120C') est située à une certaine distance des plages de connexion (12A, 12B) dans l'au moins une paire de plages de connexion dans la pluralité de plages de connexion (12A, 12B).

9. Grille de connexion prémoulée (12) selon l'une quelconque des revendications 6 à 8, dans laquelle la première extension (120A) et la deuxième extension (120B) comprennent des extensions en forme de doigt à partir des plages de connexion (12A, 12B) dans l'au moins une paire de plages de connexion dans la pluralité de plages de connexion (12A, 12B).

10. Grille de connexion prémoulée (12) selon l'une quelconque des revendications 6 à 9, dans laquelle la première extension (120A) et la deuxième extension (120B) comprennent des extensions convergeant mutuellement à partir des plages de connexion (12A, 12B) dans l'au moins une paire de plages de connexion dans la pluralité de plages de connexion (12A, 12B).

11. Dispositif à semiconducteur, comprenant :
une grille de connexion prémoulée (12) selon l'une quelconque des revendications 6 à 10, et
des composants de dispositif à semiconducteur (C, R1, R2) agencés sur les plages de connexion (12A, 12B) dans l'au moins une paire de plages de connexion dans la pluralité de plages de connexion (12A, 12B).
